Europäisches Patentamt

European Patent Office

Office européen des brevets

(11) Veröffentlichungsnummer: **0 302 130**
**A1**

(12) **EUROPÄISCHE PATENTANMELDUNG**

(21) Anmeldenummer: 87111298.3

(22) Anmeldetag: 05.08.87

(51) Int. Cl.⁴: **G03F 7/20**

(43) Veröffentlichungstag der Anmeldung:
08.02.89 Patentblatt 89/06

(84) Benannte Vertragsstaaten:
**DE FR GB IT NL**

(71) Anmelder: **PERKIN-ELMER CENSOR ANSTALT**
**Schlossstrasse 5**
**FL-9490 Vaduz(LI)**

(72) Erfinder: **Löbach, Ernst W.**
**Tonagasse 374**
**FL-9492 Eschen(LI)**

(74) Vertreter: **Hofinger, Engelbert et al**
**Torggler-Hofinger Wilhelm-Greil-Strasse 16**
**A-6020 Innsbruck(AT)**

(54) **Belichtungseinrichtung.**

(57) Belichtungseinrichtung für ein Gerät zur photolithographischen Herstellung von integrierten Schaltungen, bei der Licht einer Quecksilberdampflampe (1) über hintereingeschaltete Umlenkspiegel (6,7 bzw. 6´,7´) durch ein schmalbandiges Hauptfilter (8) geleitet wird. Zur Beseitigung der von diesem Hauptfilter (8) neben dem gewünschten Belichtungswellenlängenband ebenfalls durchgelassenen Seitenbänder sind anstelle der bisher üblichen zusätzlichen Transmissionsfilter die ohnehin vorhandenen Umlenkspiegel als wellenlängenselektive Schmalbandspiegel (6,7 bzw. 6´,7´) ausgebildet, deren Reflexionsgrad im Bereich des Belichtungswellenlängenbandes über 99 % und im Bereich der Seitenbänder unter 10 % liegt.

Fig. 1

Die Erfindung betrifft eine Belichtungseinrichtung, insbesondere für ein Gerät zur photolithographischen Herstellung von integrierten Schaltungen, bei der Licht einer Lichtquelle, insbesondere einer Quecksilberdampflampe, über hintereinandergeschaltete Umlenkspiegel durch ein für die Belichtungswellenlänge durchlässiges, schmalbandiges Filter geleitet wird, wobei Einrichtungen zur Beseitigung von wellenlängenmäßig neben der Belichtungswellenlänge liegenden und vom genannten Filter ebenfalls durchgelassenen Seitenbändern vorgesehen sind.

An derartige Belichtungseinrichtungen wird die Forderung gestellt, daß Licht einer bestimmten Wellenlänge, bei Verwendung einer Quecksilberdampflampe im allgemeinen von 405,5 nm, in größtmöglicher Stärke durchgelassen wird. Gleichzeitig soll der Anteil aller übrigen Wellenlängen so gering wie nur möglich sein.

Ein schmalbandiges Filter, welches mit der genügenden Schärfe nur die Belichtungswellenlängen durchläßt, ist notwendigerweise ein Interferenzfilter und weist damit den Nachteil auf, daß auch noch wellenlängenmäßig neben der Belichtungswellenlänge liegende Seitenbänder durchgelassen werden.Diese sind jedoch unerwünscht und werden nach dem Stand der Technik durch Zusatzfilter abgeblockt, welche vor oder nach dem schmalbandigen Hauptfilter angeordnet sind und unabhängig von ihrer Ausbildung als Interferenz- oder Absorptionsfilter als Transmissionsfilter wirken. Der Nachteil einer solchen Abblockung der Seitenbänder besteht darin, daß durch die Filtereinrichtungen zur Abblockung der Seitenbänder auch für die Belichtungswelle selbst Transmissionsverluste von typischerweise 20 % auftreten. Diese Transmissionsverluste im Bereich der Belichtungswelle sind dabei im allgemeinen umso größer, je näher die Seitenbänder beim Belichtungswellenlangenband liegen. Die Seitenbänder rücken näher zur Belichtungswellenlänge, wenn die Halbwertsbreite des schmalbandigen Hauptfilters verringert wird (beispielsweise von üblichen 12 nm auf 6 nm).

Aufgabe der Erfindung ist es, eine Belichtungseinrichtung der eingangs genannten Gattung zu schaffen, bei der die Transmission für das vom schmalbandigen Filter (Hauptfilter) definierte Belichtungswellenlängenband durch die Einrichtungen zur Blockierung der Seitenbänder nur minimal reduziert ist, und gleichzeitig die Seitenbänder im wesentlichen eliminiert sind.

Dies wird erfindungsgemäß dadurch erreicht, daß die Umlenkspiegel als wellenlängenselektive Schmalbandspiegel mit hohem Reflexionsgrad im Bereich des vom Filter durchgelassenen Belichtungswellenlängenbandes und mit wesentlich niedrigerem Reflexionsgrad im Bereich der Seitenbänder ausgebildet sind und damit die Einrichtungen zur Beseitigung der Seitenbänder bilden.

Die Erfindung geht davon aus, daß das von der Lichtquelle kommende Licht ohnedies von mehreren Spiegeln umgelenkt wird, bevor es ins Hauptfilter gelangt. Diese Spiegel können daher ohne großen baulichen Mehrfaufwand dazu verwendet werden, die bisher zur Blockierung der Seitenbänder notwendigen Transmissionsfilter zu ersetzen. Der dadurch bedingte Mehraufwand für die teuren Spiegel ist insofern mehr als gerechtfertigt, als wellenlängenselektive Schmalbandspiegel mit einem Reflexionsgrad für den interessierenden Wellenbereich zur Verfügung stehen, welcher wesentlich höher ist als der Transmissionsgrad der besten Transmissionsfilter, die ebenfalls die Seitenbänder blockieren. Unter einem hohen Reflexionsgrad der wellenlängenselektiven Schmalbandspiegel im Bereich des Belichtungswellenlängenbandes wird im Rahmen der vorliegenden Erfindung ein Reflexionsgrad verstanden, der deutlich über dem Transmissionsgrad der bisher zur Blockierung der Seitenbänder verwendeten Transmissionsfilter liegt. Hohe Reflexionsgrade, etwa über 95% sind für Schmalbandspiegel kein Problem. Gemäß einer bevorzugten Ausführungsform der Erfindung sind Schmalbandspiegel vorgesehen, deren Reflexionsgrad im Bereich des vom Filter durchgelassenen Belichtungswellenlängenbandes über 99% liegt.

Die Tatsache, daß Schmalbandspiegel auch noch in Wellenlängenbereichen - wenn auch mit wesentlich niedrigerem Reflexionsgrad - geringfügig reflektieren, welche neben dem Belichtungswellenlängenband liegen, stellt in der Praxis kaum einen Nachteil dar, da die Umlenkspiegel ohnehin hintereinandergeschaltet sind: wird beispielsweise durch den ersten Schmalbandspiegel noch etwa 10% im eigentlichen zu blockenden Wellenbereich reflektiert, so ist dies nach dem zweiten Spiegel nur mehr 1%, bezogen auf die ursprünglich einfallende Intensität in diesem Wellenlängenbereich. Wenn der Reflexionsgrad der Schmalbandspiegel im Bereich der vom Filter durchgelassenen Seitenbänder kleiner als 20%, vorzugsweise kleiner als 10% ist, so erzielt man jedenfalls eine ausreichende Unterdrückung der Seitenbänder.

Mit den erfindungsgemäß vorgesehenen wellenlängenselektiven Schmalbandspiegeln erzielt man aufgrund der unbedeutenden Reflexionsverluste im Bereich des Belichtungswellenlängenbandes für dieses Wellenlängenband eine maximale Gesamttransmission durch die Belichtungseinrichtung und insgesamt eine Blockierung aller anderen Wellenlängen inklusive der vom Hauptfilter durchgelassenen Seitenbänder, wobei bei denselben Spiegeln Hauptfilter mit unterschiedlichen Halbwertsbreiten und in bestimmtem Rahmen auch unterschiedlichen Mittenfrequenzen (beispielsweise 436,5 nm anstatt 405,5 nm) verwendbar sind. Weitere Vorteile sind die hohe Lebensdauer und die Tatsache, daß Umwelteinflüsse, wie Brechzahländerungen der Luft, praktisch keinen Einfluß haben.

Weitere Einzelheiten der Erfindung werden anschließend anhand der Zeichnung näher erläutert.

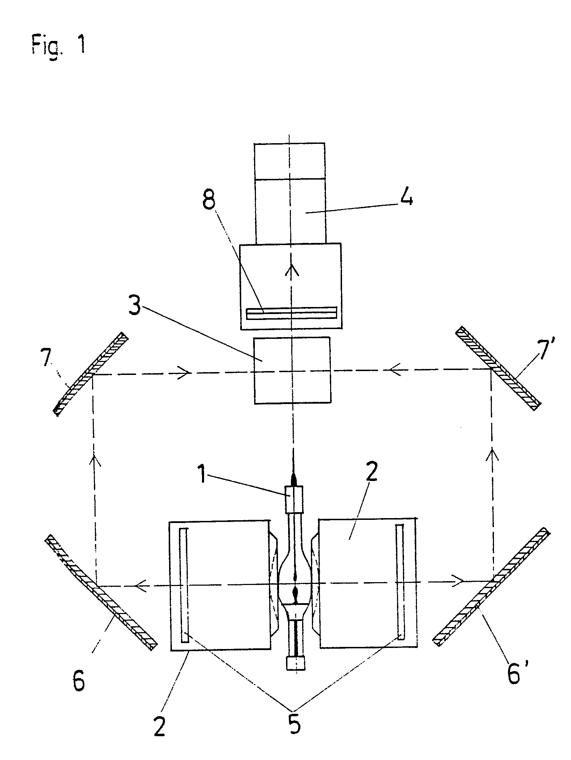

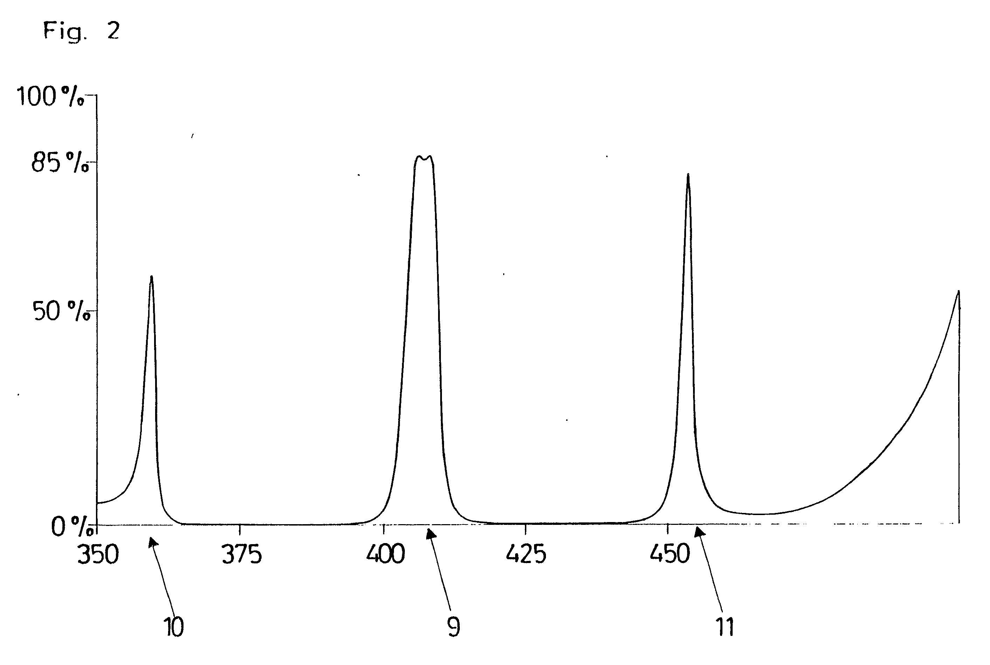

Es zeigen die Fig.1 eine schematische Darstellung eines Ausführungsbeispiels der erfindungsgemäßen Belichtungseinrichtung,und die Fig.2 die Intensitätsverteilung des aus der Belichtungseinrichtung austretenden Lichtes, wenn die Seitenbänder nicht blockiert sind.

Das von einer Quecksilberlampe 1 kommende Licht wird durch paarweise angeordnete Sammellinsen 2 auf beidseits angeordnete Paare von Schmalbandspiegeln 6,7 und 6',7' geworfen und über ein Doppelprisma 3 durch den schmalbandigen Hauptfilter 8 gelenkt, von welchem es in die Kondensorlinse 4 der Belichtungseinrichtung gelangt. Die Führung des Lichtes in zwei Strahlengängen, wie es in Fig.1 gezeigt ist, erlaubt eine höhere Lichtausbeute im Vergleich zu Anordnungen mit Hohlspiegeln, bei denen ein Lichtbündel durch das Lampenvolumen zurückgeführt wird, so daß das Lichtbündel infolge Absorption durch das emittierende Gas geschwächt wird.

Zusätzliche Filter 5 blockieren die ultraviolette Strahlung, womit die folgenden optischen Bauteile geschützt sind, und auch andere als Quarzmaterialien verwendbar sind. Außerdem kann die Belichtungseinrichtung für Justierzwecke ohne Sicherheitsrisiko geöffnet werden.

Würden anstelle der dargestellten dielektrischen Schmalbandspiegel 6,7 bzw. 6',7' gewöhnliche Spiegel verwendet sein und wäre auch sonst keine Einrichtung zur Beseitigung der Seitenbänder vorhanden, so hätte das durch den schmalbandigen Filter 8 durchgehende Licht eine Intensitätsverteilung, wie sie in Fig.2 dargestellt ist. Mit 9 ist das Belichtungswellenlängenband bezeichnet, mit 10 das ultraviolette Seitenband und mit 11 das blaue Seitenband.

Die die Belichtungswellenlänge definierende Mittenwellenlänge des Filters 8 liegt bei 405,5 nm, wobei die Halbwertsbreite etwa 6 nm beträgt. Der Transmissionsgrad dieses Filters 8 liegt bei der Mittenwellenlänge über 90%.

Die Schmalbandspiegel 6,7 bzw. 6', 7' sind vorzugsweise als Rückflächenspiegel ausgeführt, wobei die dielektrische Spiegelschicht durch ein Deckglas insbesondere gegen aggressive, durch UV-Licht erzeugte Gase und Dämpfe geschützt ist. Die Vorderseite der Spiegelsubstrate trägt keinerlei Schichten, damit sie ohne Schwierigkeiten gereinigt werden kann. Das an der Vorderseite nach Fresnel reflektierte Licht geht dem Strahlengang nicht verloren, da die Unterschiede im optischen Weg zwischen dem an der Vorderseite und dem an der Rückseite reflektierenden Licht vernachlässigbar sind.

Durch die Verwendung von solchen Schmalbandspiegeln 6,7 bzw. 6',7', deren Reflexionsgrad unter 385 nm und über 450 nm kleiner als 10 % ist, und im Bereich von 390 nm bis 420 nm über 99 % liegt, können die in Fig. 2 dargestellten Seitenbänder praktisch vollständig eliminiert werden, wie es bisher unter Anwendung von Transmissionsfiltern nur unter erheblichem Intensitätsverlust im Bereich der Belichtungswellenlänge möglich war. Durch die selektiven Schmalbandspiegel 6,7 bzw. 6',7' hingegen wird die Intensität des Belichtungswellenlängenbandes nur in einem völlig unbedeutenden Ausmaß reduziert.

## Ansprüche

1. Belichtungseinrichtung, insbesondere für ein Gerät zur photolithographischen Herstellung von integrierten Schaltungen, bei der Licht einer Lichtquelle, insbesondere einer Quecksilberdampflampe, über hintereinandergeschaltete Umlenkspiegel durch ein für die Belichtungswellenlänge durchlässiges, schmalbandiges Filter geleitet wird, wobei Einrichtungen zur Beseitigung von wellenlängenmäßig neben der Belichtungswellenlänge liegenden und vom genannten Filter ebenfalls durchgelassenen Seitenbändern vorgesehen sind, dadurch gekennzeichnet, daß die Umlenkspiegel als wellenlängenselektive Schmalbandspiegel (6,7 bzw. 6',7') mit hohem Reflexionsgrad im Bereich des vom Filter (8) durchgelassenen Belichtungswellenlängenbandes (9) und mit wesentlich niedrigerem Reflexionsgrad im Bereich der Seitenbänder (10,11) ausgebildet sind und damit die Einrichtungen zur Beseitigung der Seitenbänder (10,11) bilden.

2. Belichtungseinrichtung nach Anspruch 1, dadurch gekennzeichnet, daß aus der Lichtquelle (1) austretendes, getrennt gesammeltes Licht zunächst in zwei räumlich getrennten Strahlengängen geführt ist, wobei in jeden Strahlengang mindestens zwei hintereinanderliegende Schmalbandspiegel (6,7 bzw. 6'7') angeordnet sind, und daß das von den Schmalbandspiegeln (6,7 bzw. 6'7') reflektierte Licht der beiden Strahlengänge vereinigt und dem schmalbandigen Filter (8) zugeführt ist.

3. Belichtungseinrichtung nach Anspruch 2, dadurch gekennzeichnet, daß die Strahlengänge des von der Lichtquelle (1) stammenden, gesammelten Lichtes zunächst in zwei entgegengesetzte Richtungen verlaufen, daß zwei Paare von rechtwinkelig zueinander stehenden Schmalband spiegeln (6',7' bzw. 6',7') vorgesehen sind, die jeden Strahlengang derart um jeweils 180° umlenken, daß die Strahlengänge aus entgegengesetzten Richtungen auf einen optischen Strahlenvereinigungs- und Umlenkteil (3) treffen.

4. Belichtungseinrichtung nach einem der Ansprüche 1 - 3, dadurch gekennzeichnet, daß insbesondere bei Verwendung einer Quecksilberdampflampe (1) als Lichtquelle zwischen der Lichtquelle (1) und den Schmalbandspiegeln (6 bzw. 6') ein ultraviolette Strahlung blockierendes Filter (5) eingebracht ist.

5. Belichtungseinrichtung nach einem der Ansprüche 1 - 4, dadurch gekennzeichnet, daß der Reflexionsgrad der Schmalbandspiegel (6,7 bzw. 6',7') im Bereich des vom Filter (8) durchgelassenen Belichtungswellenlängenbandes über 99 % liegt.

6. Belichtungseinrichtung nach einem der Ansprüche 1 - 5, dadurch gekennzeichnet, daß der Reflexionsgrad der Schmalbandspiegel (6,7 bzw. 6',7') im Bereich der vom Filter (8) durchgelassenen Seitenbänder (10,11) kleiner als 20 %, vorzugsweise kleiner als 10 % ist.

7. Belichtungseinrichtung nach einem der Ansprüche 1 - 6, dadurch gekennzeichnet, daß die Belichtungswellenlänge definierende Mittenwellenlänge des Filters (8) bei 405,5 nm liegt, wobei die Halbwertsbreite etwa 6 nm und der Transmissionsgrad bei der Mittenwellenlänge über 90 % betragen, und daß der Reflexionsgrad der Schmalbandspiegel (6,7 bzw. 6',7') unter 385 nm und über 450 nm kleiner als 10 % ist und im Bereich von 390 nm bis 420 nm über 99 % liegt.

8. Belichtungseinrichtung nach einem der Ansprüche 1 - 7, dadurch gekennzeichnet, daß die Schmalbandspiegel (6,7 bzw. 6'7') mit mindestens einer dielektrischen Schicht belegt sind.

Fig. 1

Fig. 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | DE-A-3 323 852 (CANON K.K.) * Figuren 1,6; Seite 3, Zeilen 1-17; Seite 8, Zeilen 20-24; Seite 12, Zeilen 1-8; Seite 14, Zeilen 3-6 * | 1 | G 03 F 7/20 |
| A | | 2-8 | |
| X | DE-C-3 327 689 (WILHELM STAUB GmbH) * Figur 1; Spalte 2, Zeilen 3-43,63-68; Spalte 3, Zeilen 45-60 * | 1 | |
| A | | 2-8 | |
| A | SOLID STATE TECHNOLOGY, Band 23, Nr. 5, Mai 1980, Seiten 81-85, Port Washinton, New York, US; S. IWAMATSU et al.: "Deep UV porjection system" * Seite 81, Spalte 1, Zeilen 16-20; Figur 2; Seite 82, Spalten 1,2 * | 1-3 | |
| A | IEEE TRANSACTIONS ON ELECTRON DEVICES, Band ED-28, Nr. 11, November 1981, Seiten 1284-1288, IEEE, New York, US; T. MATSUZAWA et al.: "Deep UV 1: 1 projection lithography utilizing negative resist MRS" * Insgesamt * | 1 | |
| A | DE-A-3 621 527 (USHIO DENKI K.K.) * Figur 1; Ansprüche * | 1 | |

RECHERCHIERTE SACHGEBIETE (Int. Cl.4)

G 02 B 5/22
G 02 B 5/26
G 02 B 17/06
G 03 F 7/20

Der vorliegende Recherchenbericht wurde für alle Patentansprüche erstellt

| Recherchenort | Abschlußdatum der Recherche | Prüfer |
|---|---|---|
| DEN HAAG | 14-04-1988 | WESBY P.B. |